**Europäisches Patentamt**

**European Patent Office**

**Office européen des brevets**

(19)

(11) Publication number: **0 142 934**
**B1**

(12) # EUROPEAN PATENT SPECIFICATION

(45) Date of publication of patent specification: **01.06.88**

(51) Int. Cl.⁴: **H 01 F 1/04, C 30 B 7/00**

(21) Application number: **84306986.5**

(22) Date of filing: **12.10.84**

(54) **Process for the production of ordered arrays of ferromagnetic composites.**

(30) Priority: **17.11.83 US 552981**

(43) Date of publication of application:
**29.05.85 Bulletin 85/22**

(45) Publication of the grant of the patent:
**01.06.88 Bulletin 88/22**

(84) Designated Contracting States:
**DE FR GB NL**

(56) References cited:
**DE-A-2 142 368**
**DE-A-2 705 384**
**US-A-3 821 035**
**US-A-4 369 075**

(73) Proprietor: **GRUMMAN AEROSPACE CORPORATION**
**South Oyster Bay Road**
**Bethpage, NY 11714 (US)**

(72) Inventor: **Pirich, Ronald G.**
**167 Newbrook Lane**
**Bay Shore New York 11706 (US)**
Inventor: **Larson, David J.**
**15 Tasman Lane**
**Huntington Station New York 11746 (US)**

(74) Representative: **Crawford, Fiona Merle et al**
**Elkington and Fife High Holborn House**
**52/54 High Holborn**
**London WC1V 6SH (GB)**

Courier Press, Leamington Spa, England.

## Description

This invention relates to a method for directional solidification of a magnetic composite material.

The ability to produce rare earth-transition metal containing and uranium-transition metal containing systems which enclose single domains, in an ordered array, to allow the permanent magnetic properties of these materials to approach theoretical maximum limits has not been possible until now.

It is an object of this invention to provide a method for the production of ordered arrays of ferromagnetic composites comprising such systems. In practice, these permanent magnet materials offer significant manufacturing as well as application advantages over existing rare earth-cobalt permanent magnets.

In accordance with this invention, there is provided a method for the directional solidification of a magnetic composite material consisting of ordered arrays of a ferromagnetic composite selected from REM/M, REM mixtures, REM/REM/M, REU(M)/REU(M), U/M and U/UM systems, wherein RE is a rare earth metal, M is a transition or noble metal and U is uranium, which comprises the directional solidifying of a eutectic, off-eutectic or peritectic composition of a precursor alloy of a system as defined above at a solidifying rate of 0.05 to 100 cm/h and at a thermal gradient of from 10 to 1000°C/cm.

In one embodiment, the above method is employed for the production of ordered arrays of a ferromagnetic composite of a REM/M system such as $Sm_2Co_{17}/Co$ and $Sm_2Re_{17}/Fe$ wherein a precursor eutectic REM/M composition is directionally solidified at a solidifying rate of about 20 cm/h and at a thermal gradient of 200°C/cm.

In another embodiment, the above method is employed for the production of ordered arrays of a REM mixture system such as $Sm_2Co_{17}/SmCo_5$ and $Sm_2Fe_{17}/SmFe_3$ wherein a precursor peritectic REM mixture composition is directionally solidified at a solidifying rate of about 0.5 cm/h and at a thermal gradient of 100°C/cm.

In another embodiment, the above method is employed for the production of ordered arrays of a REM/REM/M system such as $(MM)_2Co_{17}/(MM)Co_5/Co$ wherein MM is a combination of a rare earths La, Ce, Nd, Pr and Sm wherein a precursor REM/REM/M composition is directionally solidified at a solidifying rate of 0.05 to 50 cm/h and at a thermal gradient of from 10 to 1000°C/cm.

In other embodiments, the above method is employed for the production of ordered arrays of the systems REU(M)/REU(M), U/M and U/UM.

The ferromagnetic composites employed in the herein disclosed method can be categorized as follows:

A. For systems REM/M, REM mixtures, REM/REM/M and REU(M)/REU(M):

  1 Single domain fibres of $(RE_xSm_{1-x})_2M_{17}$ in an M-matrix, with $0 \leq x \leq 1$ and RE=one or more of Ce, Pr Nd

  2 single domain fibres of $(RE_xSm_{1-x})_2M_{17}$ in a $(RE_ySm_{1-y})M_5$ matrix, with $0 \leq x \leq 1$ and $0 \leq y \leq 1$ and RE=one or more of Ce, Pr, Nd

  3 single domain fibres of $(RE_xSm_{1-x})M_5$ in a $(RE_ySm_{1-y})_2M_{17}$ matrix, with $0 \leq x \leq 1$ and $0 \leq y \leq 1$ and RE=one or more of Ce, Pr, Nd

  4 fibres of M in a single pinned domain $(RE_xSm_{1-z})_2M_{17}$ matrix

  5 single domain fibres of $(RE_xSm_{1-x})M_5$ in a pinned single domain $(RE_xSm_{1-x})_2M_{17}$ matrix

  6 single domain fibres of $(RE_xSm_{1-x})_2M_{17}$ in a pinned single domain $(RE_xSm_{1-x})M_5$ matrix

  7 alternating or concentric arrays of $(RE_xSm_{1-x})_2M_{17}$ and $(RE_ySm_{1-y})M_5$ single domains in a M matrix, with $0 \leq x \leq 1$ and $0 \leq y \leq 1$ and RE=one or more of Ce, Pr, Nd

  8 alternating or concentric arrays of $(RE_{1-x}Sm_x)_2M_{17}$ and $(RE_ySm_{1-y})M_5$, single domains with $0 \leq x \leq 1$ and $0 \leq y \leq 1$ and RE=one or more of Ce, Pr, Nd

  9 single domain fibres of $(RE_xSm_{1-x})M_5$ in a $(RE_ySm_{1-y})_2M_7$ matrix, with $0 \leq x \leq 1$ and $0 \leq y \leq 1$ and RE=one or more of Ce, Pr, Nd

  10 alternating or concentric arrays of $(RE_xSm_{1-x})M_5$ and $(RE_ySm_{1-y})_2M_7$, single domains, with $0 \leq x \leq 1$ and $0 \leq y \leq 1$ and RE=one or more of Ce, Nd, Pr

  11 alternating or concentric arrays of $(RE_xSm_{1-x})_2M_{17}$ and $(RE_ySm_{1-z})M_5$ single domains in a $(RE_zSm_{1-z})_2M_7$ matrix, with $0 \leq x \leq 1$ and $0 \leq (y) \leq 1$ and $0 \leq z \leq 1$ and RE=one or more of Ce, Nd, Pr

  12 alternating or concentric arrays of $(RE_xSm_{1-x})_2M_{17}$ and $(RE_ySm_{1-y})M_5$ and $(RE_zSm_{1-z})_2M_7$ single domains, and RE=one or more of Ce, Pr, Nd

  13 alternating or concentric arrays of $(RE_xSm_{1-z})_2M_{17}$ and $(RE_ySm_{1-y})M_5$ single domains and M with $0 \leq x \leq 1$ and $0 \leq y \leq 1$ and RE=one or more of Ce, Pr, Nd

  14 alternating or concentric arrays of $(RE_xSm_{1-x})_2M_{17}$ and M single domains with $0 \leq x \leq 1$ and RE=one or more of Ce, Pr, Nd

  15 single domain fibres of $(MM)_2M_{17}$ in a M-matrix

  16 single domain fibres of $(MM)_2M_{17}$ in a $(MM)M_5$ matrix

  17 single domain fibres of $(MM)M_5$ in a $(MM)_2M_{17}$ matrix

  18 alternating or concentric arrays of $(MM)_2M_{17}$ and $(MM)M_5$ single domains in a M-matrix

  19 alternating or concentric arrays of $(MM)_2M_{17}$ and $(MM)M_5$ single domains

  20 fibres of M in a pinned single domain $(MM)_2M_{17}$ matrix

21 single domain fibres of $(MM)M_5$ in a pinned single domain $(MM)_2M_{17}$ matrix

22 single domain fibres of $(MM)_2M_{17}$ in a pinned single domain $(MM)M_5$ matrix

23 single domain fibres of $(MM)M_5$ ina $(MM)_2M_7$ matrix

24 alternating or concentric arrays of $(MM)M_5$ and $(MM)_2M_7$ single domains

25 single domain fibres of $(MM)_2M_7$ in a pinned single domain $(MM)M_5$ matrix

26 alternating or concentric arrays of $(MM)_2M_{17}$ and $(MM)M_5$ and $(MM)_2M_7$ single domains

27 alternating or concentric arrays of $(MM)M_5$ and $(MM)_2M_7$ single domains and M

28 alternating or concentric arrays of $(MM)_2M_{17}$ single domains and M

wherein the above 28 systems:

*Co* refers to the transition metal *cobalt*

*Sm* refers to the rare earth metal *samarium*

*Nd* refers to the rare earth metal *neodymium*

*Pr* refers to the rare earth metal *praseodymium*

*Ce* refers to the rare earth metal *cerium*

*M* refers to one or more of the transition or noble metals

*MM* refers to some combination of the rare earth metals *lanthanum, cerium, neodymium, praseodymium* and *samarium*.

*pinned single domain* refers to single domain structures whose size is limited by an array of dispersed fibres. The fibres serve to perturb the crystal lattice of the matrix phase so as to prevent domain nucleation or domain wall motion between nearest neighbour domains of the matrix phase. In the single domain structure, the easy axis of magnetization is parallel to the major axis and growth direction.

*single domain fibre* refers to a regularly shaped structure with a large aspect ratio whose easy axis of magnetization is parallel to the major axis and growth direction.

B. For systems U/M and U/UM:

1 single domain fibres of $(RE_xU_{1-x})_2M_{11}$ in a M matrix, with $0 \leq x \leq 1$

2 single domain fibres of $(RE_xU_{1-x})_2M_{11}$ in a $(RE_yU_{1-y})M_4$ matrix with $0 \leq x \leq 1$ and $0 \leq y \leq 1$

3 alternating or concentric arrays of $(RE_xU_{1-x})_2M_{11}$ and $(RE_yU_{1-y})M_4$ single domains in a M matrix with $0 \leq x \leq 1$ and $0 \leq y \leq 1$

4 alternating or concentric arrays of $(RE_xU_{1-x})_2M_{11}$ and $(RE_yU_{1-y})M_4$ and $(RE_zU_{1-z})M_3$ single domains in a M matrix with $0 \leq x \leq 1$, $0 \leq y \leq 1$ and $0 \leq z \leq 1$

5 single domain fibres of $(RE_yU_{1-y})M_4$ in a pinned single domain $(RE_xU_{1-x})_2M_{11}$ matrix with $0 \leq x \leq 1$ and $0 \leq y \leq 1$

6 fibres of M in a pinned single domain $(RE_xU_{1-x})_2M_{11}$ matrix with $0 \leq x \leq 1$

7 single domain fibres of $(MM_xU_{1-x})_2M_{11}$ in a M matrix with $0 \leq x \leq 1$

8 single domain fibres of $(MM_xU_{1-x})_2M_{11}$ in a $(MM_yU_{1-y})M_4$ matrix with $0 \leq x \leq 1$ and $0 \leq y \leq 1$

9 alternating or concentric arrays of $(MM_xU_{1-x})_2M_{11}$ and $(MM_yU_{1-y})M_4$ single domains in a M matrix with $0 \leq x \leq 1$ and $0 \leq y \leq 1$

10 alternating or concentric arrays of $(MM_xU_{1-x})_2M_{11}$ and $(MM_yU_{1-y})M_4$ and $(MM_zU_{1-z})M_3$ single domains in a M matrix with $0 \leq x \leq 1$, $0 \leq y \leq 1$ and $0 \leq z \leq 1$

11 single domain fibres of $(MM_yU_{1-y})M_4$ in a pinned single domain $(MM_xU_{1-x})_2M_{11}$ matrix with $0 \leq x \leq 1$ and $0 \leq y \leq 1$

12 fibres of M in a pinned single domain $(MM_xU_{1-x})_2M_{11}$ matrix with $0 \leq x \leq 1$

wherein the above 12 systems:

*RE* refers to one or more of the rare earth metals

*M* refers to one or more of the transition or noble metals

*MM* refers to some combination of the rare earth metals *lanthanum, cerium, neodymium, praseodymium* and *samarium*

*U* refers to the actinide *uranium*.

*pinned single domain* refers to single domain structures whose size is limited by an array of dispersed fibres. The fibres serve to perturb the crystal lattice of the matrix phase so as to prevent domain nucleation or domain wall motion between nearest neighbour domains of the matrix phase. In the single domain structure, the easy axis of magnetization is parallel to the major axis and growth direction.

*single domain fibre* refers to a regularly shaped structure with a large aspect ratio whose easy axis of magnetization is parallel to the major axis and growth direction.

The method employed herein for the production of ordered arrays of ferromagnetic composites selected from the systems just described involves the directional solidification of a eutectic, off-eutectic or peritectic composition of a precursor alloy of the aforedescribed systems at a solidifying rate of 0.05 to 100 cm/h at a thermal gradient of from 10 to 1000°C/cm.

More particularly, the directional solidification of eutectic, off-eutectic and peritectic compositions involves the steps of:

1 Preparation of starting solidification charges using high purity (99.999) rare earth, transition metal and/or uranium which are melted together in an evacuated, pyrolyzed boron nitride crucible above about 1300°C, i.e. the temperature at which the specific REM/M, REM mixture, REM/REM/M, REU(M)/REU(M), U/M and U/UM compound forms. The melt is electromagnetically stirred using RF induction heating until a uniform starting composition is achieved.

2 Portions of these starting charges are then remelted in a specially designed pyrolyzed boron nitride/aluminium oxide inner/outer, evacuated sample crucible and directionally solidified in a three zone Bridgman-Stockbarger apparatus. The three zones are individually controlled so as to maintain the desired thermal gradient and yet achieve unidirectional heat flow (directional solidification) at the advancing liquid-solid interface. Solidification is performed in either sealed or active vacuum pumping conditions.

3 Controlled directional solidification produces an aligned array of single domain-type ferromagnetic species, whose cross-sectional morphology is dependent on the specific alloy system and solidification processing conditions.

Reference is now made to the accompanying drawings, in which:

Figure 1a is a representation of a eutectic phase diagram;

Figures 1b, 1c, and 1d depict the plane fronts for various directional solidifications of magnetic composite materials;

Figure 1e depicts a plane front solidification with radial extraction of heat resulting in domain structures parallel to the radial growth direction;

Figures 2a, 2b, and 2c depict coupled, aligned composite arrays of solidified alloys; and

Figure 2d depicts a solidified alloy in an aligned composite array of more than two phases.

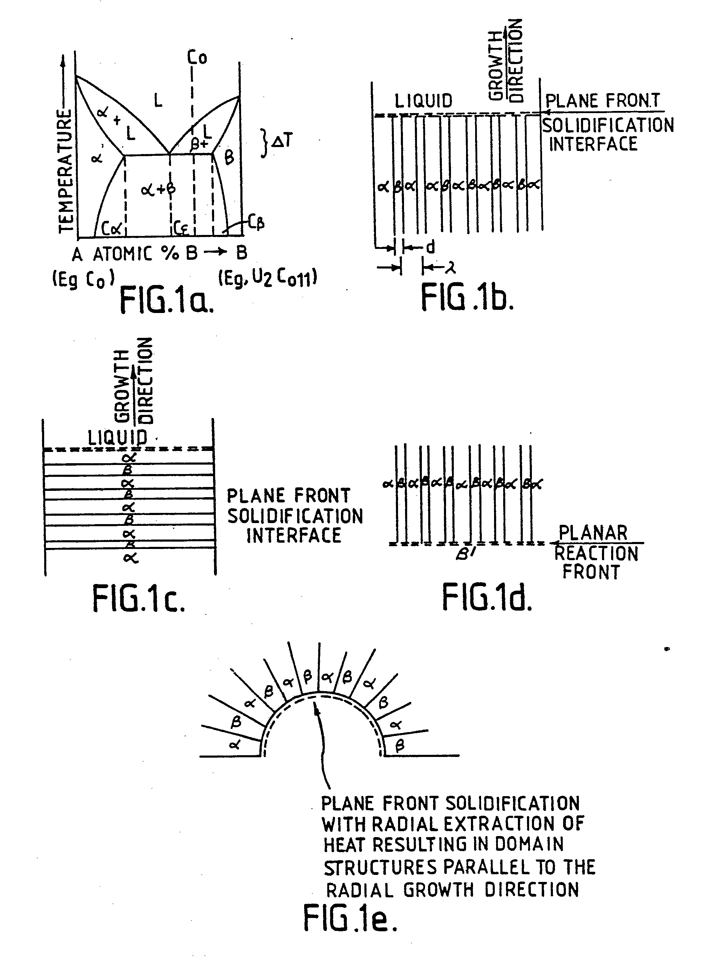

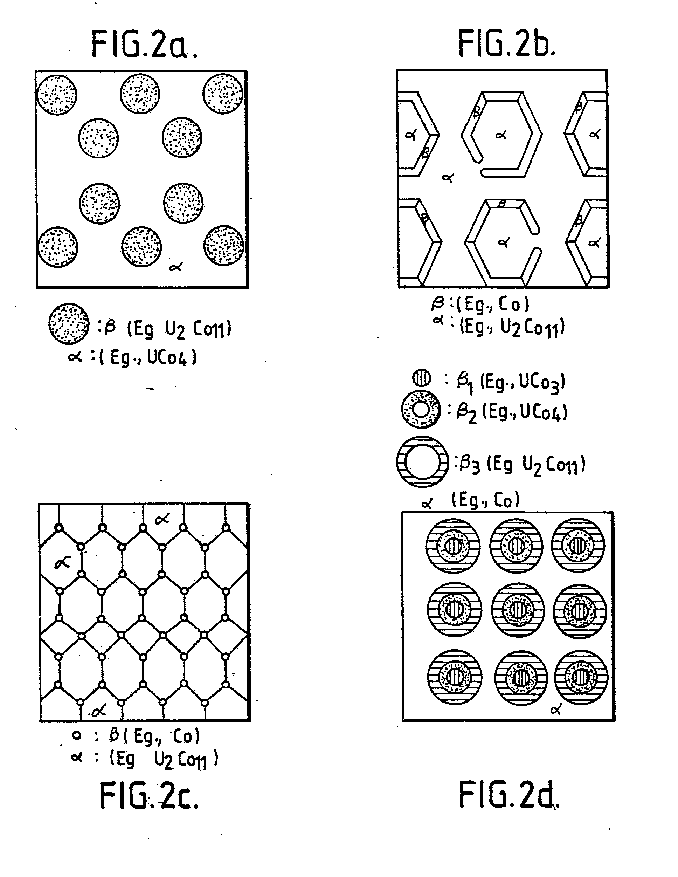

As is seen in Figure 1a (which represents a typical eutectic phase diagram), it is possible to undercool the melt by an amount $\Delta T$ in eutectic, off-eutectic and peritectic directional solidification to achieve coupled, aligned composite arrays (see Figures 2a, 2b and 2c), at some intermediate alloy composition of Co where Co lies between the maximum composition of the terminal solid solution $C_\beta$ and the composition of the eutectic compound $C_E$. It is also possible to solidify these alloys in aligned composite arrays of more than two (2) phases (in alternating or concentric arrays, see Figure 2d) since ternary or more complex alloy systems solidify via a eutectic reaction.

This undercooling can be accomplished by an appropriate choice of the ratio G/V (where G is the thermal gradient at the solidification interface and V is the rate at which the plane front solidification interface moves). Since the diameter of the eutectic compound fibres, d, and the inter-fibre spacing, $\lambda$, is also a function of G and V and the composition Co,

$$d = f(G, V, Co)$$
$$\lambda = g(G, V, Co).$$

It is possible to establish an ordered array of fibres of $\beta$ (and/or $\beta_1$, $\beta_2$) in a matrix such that d lies within the dimensions necessary for magnetic single domains and $\lambda$ is small enough to ensure a large volume fraction of the permanent magnet phase (see Figure 1b) and/or the matrix will consist of magnetic as well as either pinned (as in Figure 2c) or isolated and enclosed single domains (as in Figure 2b).

The specific manufacturing and application advantages of systems described above in Category A over existing rare earth-cobalt magnets are:

1 Eliminate grinding, pressing and sintering operations.
2 Eliminate non-uniformity of particle shape.
3 Eliminate necessity to align particles in an external magnetic field.
4 Eliminate strain induced by grinding particles.
5 Eliminate necessity to anneal final product to reduce strain.
6 Eliminate oxidation of final product due to anneal.
7 Significantly reduce adverse oxidation of rare earth-cobalt composite particles by growing them (and thus permanently enclosing them) in a protective matrix.
8 Significantly improve ductility and machinability of final product material.
9 Increase significantly number of medical and biological applications of rare earth-cobalt magnets since oxidation and subsequent decomposition will be greatly reduced.
10 Increase significantly dynamic applications since recoil energy will be nearly maximised and lack of oxidation and subsequent decomposition will allow use of these magnetic composites at elevated temperatures ($\gtrsim 150°C$).

Improvement of these systems over the best existing permanent magnets include:

1 Up to a 40% increase in saturation magnetization, $M_s$.
2 Up to a 70% increase in remanent induction, $B_r$.
3 Up to a 170% increase in static energy product, $(BH)_{max}$.
4 Up to a 300% increase in dynamic energy product or useful recoil energy $(BH)_u$.
5 Significant increase in the intrinsic coercivity, $H_{ci}$ or $_MH_c$ approaching the anisotropy field $H_A$. This represents an increase up to 300% over the best current intrinsic coercivities.

6 The ability to "tune" or adjust the various figures of merit to achieve a maximised set of characteristics for differing applications by changing the chemistry and/or morphology of these magnetic composites.

The specific manufacturing and application advantages of systems described above in Category B over existing rare earth-cobalt magnets are:

1 Eliminate grinding, pressing and sintering operations.
2 Eliminate non-uniformity of particle shapes.
3 Eliminate necessity to align particles in an external magnetic field.
4 Eliminate strain induced by grinding particles.
5 Eliminate necessity to anneal final product to reduce strain.
6 Eliminate oxidation of final product due to anneal.
7 Significantly reduce adverse oxidation of rare earth-cobalt composite particles by growing them (and thus permanently enclosing them) in a protective matrix.
8 Significantly improve ductility and machinability of final product material.
9 Increase significantly number of medical and biological applications of rare earth-cobalt magnets since oxidation and subsequent decomposition will be greatly reduced.
10 Increase significantly dynamic applications since recoil energy will be nearly maximised and lack of oxidation and subsequent decomposition will allow use of these magnetic composites at elevated temperatures ($\geqslant 150°C$).
1 Since U availability in stable (radioactive-cool) $UF_4$ and $UF_6$ exceeds the present world inventory of rare earth by a factor of $\times 1000$ the anticipated shortage of rare earth in future magnet applications will be eliminated.
12 Significant cost savings per pound over rare earth-cobalt magnets through use of uranium and transition and noble metal additions other than cobalt.

Improvement of these systems over the best existing permanent magnets include:

1 Ability to equal present or future anticipated permanent magnet figures of merit such as remanent induction $(B_r)$ or static and dynamic energy product $(BH)_{static}$ and $(BH)_{dynamic}$ through alloying with rare earth or misch-metal additions.

The ability to grow aligned U/M, U/UM and REU/REU compounds in an ordered array enables:

1 The growth of single domain particles for the first time.
2 The shape of the single domains to be very long fibres which nearly maximise the shape anisotropy for particles in the shape of a prolate spheroid (see Figs. 2a, 2b, 2c and 2d).
3 The near alignment of all single domain structures along the growth direction (which corresponds to the easy-axis of magnetization) thus nearly maximising the effect of the very large magnetocrystalline anisotropies of these compounds.

## Claims

1. A method for the directional solidification of a magnetic composite material consisting of ordered arrays of a ferromagnetic composite selected from REM/M; REM mixtures; REM/REM/M; REU(M)/REU(M); U/M and U/UM systems, wherein RE is a rare earth metal, M is a transition or noble metal and U is uranium, which comprises the directional solidifying of a eutectic, off-eutectic or peritectic composition of a precursor alloy of a system as defined above at a solidifying rate of 0.05 to 100 cm/h and at a thermal gradient of from 10 to 1000°C/cm.

2. The method of claim 1 for the production ordered arrays of a ferromagnetic composite of a REM/M system, wherein a precursor eutectic REM/M composition is directionally solidified at a solidifying rate of about 20 cm/h and at a thermal gradient of 200°C/cm.

3. The method of claim 2 for the production of $Sm_2Co_{17}/Co$ (5:1 by weight).

4. The method of claim 2 for the production of $Sm_2Fe_{17}/Fe$ (5:1 by weight).

5. The method of claim 1 for the production of ordered arrays of a ferromagnetic composite of a REM mixture system, wherein a precursor peritectic REM mixture composition is directionally solidified at a solidifying rate of about 0.5 cm/h and at a thermal gradient of 100°C/cm.

6. The method of claim 5 for the production of $Sm_2Co_{17}/SmCo_5$ (1:3 by weight).

7. The method of claim 5 for the production of $Sm_2Fe_{17}/SmFe_3$ (5:1 by weight).

8. The method of claim 1 for the production of ordered arrays of a ferromagnetic composite of a REM/REM/M system wherein a precursor REM/REM/M composition is directionally solidified at a solidifying rate of 0.05 to 50 cm/h and at a thermal gradient of from 10 to 1000°C/cm.

9. The method of claim 8 for the production of $(MM)_2Co_{17}/(MM)Co_5/Co$ wherein MM is a combination of rare earths La, Ce, Nd, Pr and Sm.

10. The method of claim 1 for the production of ordered arrays of a ferromagnetic composite of a REU(M)/REU(M) system, wherein a precursor REU(M)/REU(M) composition is directionally solidified at a solidifying rate of 0.05 to 50 cm/h and at a thermal gradient of from 10 to 1000°C/cm.

11. The method of claim 1 for the production of ordered arrays of a ferromagnetic composite of a U/M system, wherein a precursor U/M composition is directionally solidified at a solidifying rate of 0.05 to 50 cm/h and at a thermal gradient of from 10 to 1000°C/cm.

12. The method of claim 1 for the production of ordered arrays of a ferromagnetic composite of a U/UM system, wherein a precursor U/UM composition is directionally solidified at a solidifying rate of 0.05 to 50 cm/h and at a thermal gradient of from 10 to 1000°C/cm.

**Patentansprüche**

1. Verfahren zur gerichteten Verfestigung eines magnetischen zusammengesetzten Materials, bestehend aus geordneten Anordnungen aus einem ferromagnetischen zusammengesetzten Material, gewählt aus REM/M; REM-Mischungen; REM/REM/M; REU(M)/REU(M); U/M und U/UM-Systemen, worin RE ein Seltene Erden-Metall, M ein Übergangs- oder Edelmetall und U Uran ist, umfassend das gerichtete Verfestigen einer eutektischen, außereutektischen oder peritektischen Zusammensetzungen aus einer Vorläuferlegierung eines Systems, wie oben definiert, bei einer Verfestigungsgeschwindigkeit von 0,05 bis 100 cm/Stunde und bei einem Wärmegradienten von 10 bis 1000°C/cm.

2. Verfahren nach Anspruch 1 zur Herstellung geordneter Anordnungen aus einem ferromagnetischen zusammengesetzten Material aus einem REM/M-System, wobei eine eutektische REM/M-Vorläufer-Zusammensetzung bei einer Verfestigungsgeschwindigkeit von etwa 20 cm/Stunde und bei einem Wärmegradienten von 200°C/cm gerichtet verfestigt wird.

3. Verfahren nach Anspruch 2 zur Herstellung von $Sm_2Co_{17}$/Co (Gewichtsverhältnis 5:1).

4. Verfahren nach Anspruch 2 zur Herstellung von $Sm_2Fe_{17}$/Fe (Gewichtsverhältnis 5:1).

5. Verfahren nach Anspruch 1 zur Herstellung geordneter Anordnungen aus einem ferromagnetischen zusammengesetzten Material aus einem REM-Mischungs-System, wobei eine peritektische REM-Mischungs-Vorläuferzusammensetzung bei einer Verfestigungsgeschwindigkeit von etwa 0,5 cm/Stunde und bei einem Wärmegradienten von 100°C/cm gerichtet verfestigt wird.

6. Verfahren nach Anspruch 5 zur Herstellung von $Sm_2Co_{17}$/SmCo_5 (Gewichtsverhältnis 1:3).

7. Verfahren nach Anspruch 5 zur Herstellung von $SmFe_{17}$/SmFe_3 (Gewichtsverhältnis 5:1).

8. Verfahren nach Anspruch 1 zur Herstellung geordneter Anordnungen aus einem ferromagnetischen zusammengesetzten Material aus einem REM/REM/M-System, wobei eine REM/REM/M-Vorläuferzusammensetzung bei einer Verfestigungsgeschwindigkeit von 0,05 bis 50 cm/Stunde und bei einem Wärmegradienten von 10 bis 1000°C/cm gerichtet verfestigt wird.

9. Verfahren nach Anspruch 8 zur Herstellung von $(MM)_2CO_{17}$/(MM)Co_5/Co, worin MM eine Kombination der Seltenen Erden La, Ce, Nd, Pr und Sm ist.

10. Verfahren nach Anspruch 1 zur Herstellung geordneter Anordnungen aus einem ferromagnetischen zusammengesetzten Material aus einem REU(M)/REU(M)-System, wobei eine REU(M)/REU(M)-Vorläuferzusammensetzung bei einer Verfestigungsgeschwindigkeit von 0,05 bis 50 cm/Stunde und bei einem Wärmegradienten von 10 bis 1000°C/cm gerichtet verfestigt wird.

11. Verfahren nach Anspruch 1 zur Herstellung geordneter Anordnungen aus einem ferromagnetischen zusammengesetzten Material aus einem U/M-System, wobei eine U/M-Vorläuferzusammensetzung bei einer Verfestigungsgeschwindigkeit von 0,05 bis 50 cm/Stunde und bei einem Wärmegradienten von 10 bis 1000°C/cm gerichtet verfestigt wird.

12. Verfahren nach Anspruch 1 zur Herstellung geordneter Anordnungen aus einem ferromagnetischen zusammengesetzten Material aus einem U/UM-System, wobei eine U/UM-Vorläuferzusammensetzung bei einer Verfestigungsgeschwindigkeit von 0,05 bis 50 cm/Stunde und bei einem Wärmegradienten von 10 bis 1000°C/cm gerichtet verfestigt wird.

**Revendications**

1. Procédé de solidification directionnelle d'une matière composite magnétique consistant en structures orientées d'un composite ferromagnétique choisi parmi les systèmes REM/M; mélanges REM; REM/REM/M; REU(M)/REU(M); U/M et U/UM, dans lesquels RE est un métal des terres rares, M est un métal de transition ou un métal noble, et U est l'uranium, caractérisé en ce qu'il consiste à effectuer la solidification directionnelle d'une composition eutectique, hors-eutectique ou péritectique d'un alliage précurseur d'un système tel que défini ci-dessus, à une vitesse de solidification de 0,05 à 100 cm/h et à un gradient thermique de 10 à 1000°C/cm.

2. Procédé selon la revendication 1, pour la production de structures orientées d'un composite ferromagnétique d'un système REM/M, caractérisé en ce qu'il consiste à effectuer la solidification directionnelle d'une composition REM/M eutectique en tant que précurseur, à une vitesse de solidification d'environ 20 cm/h et à un gradient thermique de 200°C/cm.

3. Procédé selon la revendication 2, caractérisé en ce qu'il est appliqué à la production de $Sm_2Co_{17}$/Co (5:1 en poids).

6

4. Procédé selon la revendication 2, caractérisé en ce qu'il est appliqué à la production de $Sm_2Fe_{17}$/Fe (5:1 en poids).

5. Procédé selon la revendication 1, caractérisé en ce qu'il est appliqué à la production de structures orientées d'un composite ferromagnétique d'un système de mélange REM, suivant lequel on effectue la solidification directionnelle d'une composition de mélange REM péritectique en tant que précurseur, à une vitesse de solidification d'environ 0,5 cm/h et à un gradient thermique de 100°C/cm.

6. Procédé selon la revendication 5, caractérisé en ce qu'il est appliqué à la production de $Sm_2Co_{17}$/$SmCo_5$ (1:3 en poids).

7. Procédé selon la revendication 5, caractérisé en ce qu'il est appliqué à la production de $Sm_2Fe_{17}$/$SmFe_3$ (5:1 en poids).

8. Procédé selon la revendication 1, caractérisé en ce qu'il est appliqué à la production de structures orientées d'un composite ferromagnétique d'un système REM/REM/M, suivant lequel on effectue la solidification directionnelle d'une composition REM/REM/M en tant que précurseur, à une vitesse de solidification de 0,05 à 50 cm/h et à un gradient thermique de 10 à 1000°C/cm.

9. Procédé selon la revendication 8, caractérisé en ce qu'il est appliqué à la production de $(MM)_2Co_{17}$/$(MM)CO_5$/Co, suivant lequel MM est une combinaison des métaux des terres rares La, Ce, Nd, Pr et Sm.

10. Procédé selon la revendication 1, caractérisé en ce qu'il est appliqué à la production de structures orientées d'un composite ferromagnétique d'un système REU(M)/REU(M), suivant lequel on effectue la solidification directionnelle d'une composition REU(M)/REU(M) en tant que précurseur, à une vitesse de solidification de 0,05 à 50 cm/h et à un gradient thermique de 10 à 1000°C/cm.

11. Procédé selon la revendication 1, caractérisé en ce qu'il est appliqué à la production de structures orientées d'un composite ferromagnétique d'un système U/M, suivant lequel on effectue la solidification directionnelle d'une composition U/M en tant que précurseur, à une vitesse de solidification de 0,05 à 50 cm/h et à un gradient thermique de 10 à 1000°C/cm.

12. Procédé selon la revendication 1, caractérisé en ce qu'il est appliqué à la production de structures orientées d'un composite ferromagnétique d'un système U/UM, suivant lequel on effectue la solidification directionnelle d'une composition U/Um en tant que précurseur, à une vitesse de solidification de 0,05 à 50 cm/h et à un gradient thermique de 10 à 1000°C/cm.

0 142 934

FIG.1a.

FIG.1b.

FIG.1c.

FIG.1d.

PLANE FRONT SOLIDIFICATION
WITH RADIAL EXTRACTION OF
HEAT RESULTING IN DOMAIN
STRUCTURES PARALLEL TO THE
RADIAL GROWTH DIRECTION

FIG.1e.

1

0 142 934

FIG.2a.

:β (Eg U$_2$ Co$_{11}$)
∝ :( Eg., UCo$_4$)

FIG.2b.

β:(Eg., Co)
∝: (Eg., U$_2$ Co$_{11}$)

: β$_1$ (Eg., UCo$_3$)
: β$_2$ (Eg., UCo$_4$)
:β$_3$ (Eg U$_2$ Co$_{11}$)
∝ (Eg., Co)

FIG.2c.

o : β( Eg., Co)
∝ : (Eg U$_2$ Co$_{11}$ )

FIG.2d.

2